# EUROPÄISCHE PATENTANMELDUNG

(11) **EP 2 058 870 A2**
(43) Veröffentlichungstag der Anmeldung: **13.05.2009**
(21) Anmeldenummer: 08019335.2
(22) Anmeldetag: 05.11.2008
(51) Int. Cl.: H01L 31/08, H01L 31/0392, H01L 31/18

(54) **Kontaktierung und Modulverschaltung von Dünnschichtsolarzellen auf polymeren Trägern**

(30) Priorität: 07.11.2007 DE 102007052971
(71) Anmelder: SolarionAG Photovoltaik, 04288 Leipzig (DE)
(72) Erfinder: Braun, Alexander, 04103 Leipzig (DE); Böhme, Rico, 04157 Leipzig (DE); Zimmer, Klaus, 04668 Klinga (DE)
(74) Vertreter: Nenning, Peter

(57) **Zusammenfassung**

Die Erfindung betrifft eine Modulverschaltung von Dünnschichtsolarzellen auf polymeren Trägern. Es ist die Aufgabe gestellt, die zur Gewinnung von Solarenergie nutzbare Fläche zu vergrößern und die serielle Verschaltung von Solarzellenmodulen zu erleichtern und zu effektivieren. Die Aufgabe wird gelöst durch das Anbringen der elektrischen Kontakte auf der Rückseite der Dünnschichtsolarzellen nach einer besonderen Lasertechnologie und das Verschalten der Dünnschichtsolarzellen zu Modulen.

## Beschreibung

Die Erfindung betrifft eine Anordnung zur elektrischen Kontaktierung von auf der Dünnschichtsolarzellenfolie aufgebrachten Schichten, die eine Elektrode der Solarzelle repräsentiert und ein Verfahren zur Herstellung derartiger elektrischer Kontakte für Dünnschichtsolarzellen auf polymeren Trägern. Weiterhin umfasst die Erfindung eine Anordnung sowie ein Verfahren zur elektrischen Zusammenschaltung von Dünnschichtsolarzellen mit rückseitigem Zugang zu der auf dem Substrat angeordneten Solarzellenelektrode zu Modulen oder Teilen von Modulen. Insbesondere erstreckt sich die Erfindung auf Dünnschichtsolarzellen auf Basis von Kupfer-Indium-Gallium-Diselinid (CIGS) oder verwandten Chalkopyrit-Absorbern, die auf Polymerfolie hergestellt sind.

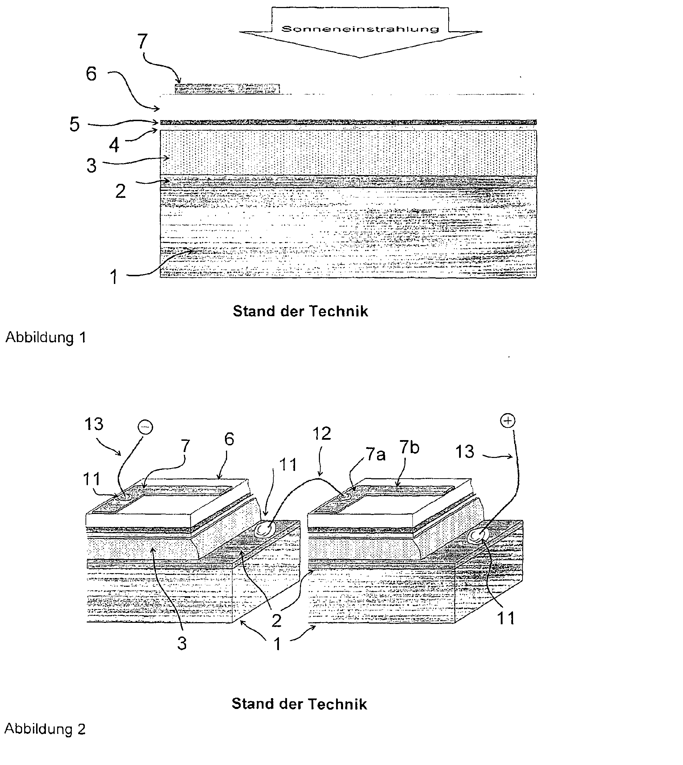

Dünnschichtsolarzellen können auf starre Träger, beispielsweise Glas, aber auch auf Folien, also dünne, flexible Träger aus Metall oder Polymer, abgeschieden werden. Der prinzipielle Aufbau einer Dünnschichtsolarzelle ist in Abbildung 1 anhand einer CIGS-Dünnschichtsolarzelle auf Folienbasis dargestellt und umfasst die Trägerfolie (1), den metallischen Rückkontakt (2), der im Beispiel im Wesentlichen eine Molybdänschicht umfasst, die Absorberschicht aus zum Beispiel CIGS (3), eine Pufferschicht aus zum Beispiel Cadmiumsulfid (4), einen Tunnelkontakt aus zum Beispiel intrinsischem Zinkoxid (5), die transparente Vorderseitenelektrode, die aus einem transparenten oxidischen Leiter wie beispielsweise Indiumzinnoxid (ITO - indium tin oxide) besteht. Vorteilhaft zur Herstellung von Dünnschichtsolarzellen ist die kontinuierliche Prozessführung bei der Schichtabscheidung, wobei vorzugsweise ein Rolle-zu-Rolle-Prozess umgesetzt wird. Die dabei entstehenden "Endlos"-Solarzellen müssen zur effizienten Nutzung der Solarenergie, zur Anpassung an Nutzungserfordernisse und zur Realisierung anwendungsspezifischer Designs entsprechend konfektioniert werden. Ein wesentlicher Aspekt ist dabei die serielle Verschaltung, d. h. die Zusammenschaltung von kleineren Solarzellen in Reihenschaltung, wobei die Kathode einer Zelle mit der Anode der folgenden Zelle mittels elektrischer Verbindungselemente (12), dies sind üblicherweise metallische Drähte oder Bänder, und Kontaktierungselementen (11) verbunden wird, wie dies schematisch in Abbildung 2 gezeigt ist. Die elektrische Energie steht an den Endpunkten der serienverschalteten Solarzellen an elektrischen Leitungen (13) zur Verfügung, so in DE 20 2004 000 205 U1 beschrieben und in JP 06029564, in der die versetzte Kontaktierung flexibler Dünnschichtsolarzellen dargestellt wird. Durch die serielle Verschaltung von Einzelsolarzellen, die beispielsweise aus dem im Rolle-zu-Rolle-Verfahren hergestellten Solarzellenband herausgelöst wurden, zu Modulen ist eine Erhöhung der Ausgangsspannung des Moduls und eine Verminderung des Stromes durch die Solarzellen bei gleicher Solarzellenfläche möglich sowie insgesamt eine Erhöhung der Effizienz erzielbar.

Neben der einfachen seriellen Verschaltung von Solarzellen sind die parallele Zusammenschaltung sowie komplexere Verschaltungsmöglichkeiten als Kombination von Reihen- und Parallelschaltung bekannt.

Die serielle Verschaltung von großflächig abgeschiedenen Dünnschichtsolarzellen kann auf einem Substrat durch eine sogenannte monolithisch integrierte Verschaltung erreicht werden. Hierfür ist ein komplexer Herstellungsprozess mit ineinander greifenden Prozessen der Schichtabscheidung und Schichtstrukturierung erforderlich. So werden beispielsweise in DE 100 17 610 A1 Schattenmasken zur Strukturgenerierung bei der Schichtabscheidung angewendet. Üblicherweise wird allerdings das Laserritzen in alternierender Kombination mit den Schichtabscheideprozessen zur Herstellung von integriert seriell verschalteten Dünnschichtsolarzellen verwendet, wie in US 7,259,321 B2 beschrieben ist.

Da die integrierte Verschaltung von Dünnschichtsolarzellen auf Folien noch deutlich anspruchsvoller ist, werden alternative Wege beschritten, die auf der Zusammenschaltung von mehreren einzelnen Solarzellen beruhen, die auf einen gemeinsamen Träger gebracht und mit zusätzlichen Verbindungselementen miteinander elektrisch verbunden werden. DE 331 7309 C2 beansprucht eine Anordnung zur Kontaktierung/Verschaltung von auf eine spezielle Trägerfolie gebrachten Solarzellen, wobei die in der Trägerfolie verfügbaren Metalldrähte lokal beispielsweise mit Laserstrahlung freigelegt werden und so, nach Verbindung der freigelegten Stellen mit den Kontakten der Solarzelle mittels Löt- und Klebetechnik, die Verschaltung über die Trägerfolie realisiert wird. In anderer Ausführung wird in JP 2001 077 395 A die Verbindung von Einzelsolarzellen außerhalb der aktiven Fläche auf einem Trägermaterial (Laminat) vorgeschlagen und hierfür Verbindungselemente zur Verbindung der Kontakte benachbarter Solarzellen aufgebracht. In anderer Verfahrensweise werden in JP 2000 196 116 A nach Laminierung von Einzelsolarzellen auf einen Träger in diesen Löcher mittels Laserbeschusses an den Stellen der Solarzellenkontakte eingebracht, so dass in der Folge die Kontakte über die auflaminierte Folie elektrisch verbunden werden können, ohne mit der Vorderseitenelektrode der Solarzelle einen elektrischen Kurzschluss zu verursachen.

Um die Vorteile von rückseitig, d. h. auf der sonnenabgewandten Seite der Dünnschichtsolarzelle, verfügbaren Kontakten im Sinne der integrierten Verschaltung nutzen zu können, wird in US 2005/0011551 A1 ein die Folienkante umfassender Kontakt vorgeschlagen, der eine elektrische Verbindung der Vorder- mit der Rückseite der Folie an den Kanten realisiert. Hierfür wird eine Reihe von Prozessschritten, wie beispielsweise das Aufbringen von Schichten, zusätzlich notwendig. US 5,453, 134 schließlich beschreibt eine weitere Form der Verschaltung. Der Vorteil der Verfügbarkeit der Solarzellenkontakte auf der sonnenabgewandten Rückseite der Solarzelle wird in WO 2007/096752A2 genutzt, um über eine perforierte Folie zur Isolierung die elektrische Verbindung der Solarzelle z. B. mit Siebdruck zu ermöglichen. Derartige Rückseitenverschaltungsvarianten ermöglichen einen hohen Automatisierungsgrad und die Realisierung anpassungsfähiger Solarzellendesignvarianten.

Eben aufgrund der guten Automatisierbarkeit werden zunehmend Laserprozesse in der Solarzellenherstellung angewendet. Beispiele sind das Ritzen dünner Schichten zur integrierten Verschaltung, das Bohren von Siliziumsolarzellen zur Durchführung der Solarzellenkontakte/-elektroden auf die Siliziumscheibenrückseite sowie das Beschneiden von Wafern. Für die unterschiedlichen Anwendungen sind jeweils spezifisch Prozessbedingungen erforderlich, um die Qualität sicherzustellen.

Es ist bekannt, dass die Bestrahlung von Polymeren mit gepulster Laserstrahlung ausreichender Intensität zu einem Materialabtrag führen kann. Dieser Prozess wird als Laserablation bezeichnet und ist durch eine materialspezifische Abtragsschwelle gekennzeichnet. Besonders Polymere mit einem hohen Absorptionskoeffizient lassen sich gut abtragen und so auch Öffnungen in Materialien oder Schichten einbringen.

Die geschilderten bekannten technischen Lösungen haben eine Reihe von Nachteilen. Das fundamentale Defizit der bestehenden Anordnungen und Methoden zur seriellen Verschaltung von Dünnschichtsolarzellen ist der Flächenverlust von aktiver Solarzellenfläche bzw. Modulfläche durch Elemente, die zur Verschaltung erforderlich sind. Dies betrifft entweder die Gebiete der monolithisch integrierten Verschaltung, eingebrachte Löcher, aufgebrachte Kontakte und/oder zusätzliche elektrische Verschaltungselemente, z. B. also Drähte. Weiterhin sind eine Reihe von technologischen Schritten und zusätzliche Verbindungselemente erforderlich, um die Vorderseitenkontakte auf die Rückseite des Dünnschichtsolarzellenfolienträgers zu führen. Allgemeine Folgen sind eine nicht optimale Ausnutzung der Modulfläche zur Energiewandlung, erhöhte technologische Aufwendungen und zusätzliche Verbindungselemente.

Infolge dessen ist die Aufgabe der Erfindung, eine Anordnung zur Kontaktierung von dünnen Schichten von Dünnschichtsolarzellen auf polymeren Trägern zu schaffen, die eine hohe Ausnutzung der eingestrahlten Solarenergie zur Energiewandlung bei geringem technischem Aufwand ermöglicht. Dies soll durch die Verlagerung von Kontaktelementen auf die sonnenabgewandte Rückseite der Solarzellenträgerfolie erfolgen. Weiterhin besteht die Aufgabe darin, eine Anordnung zur elektrischen Verbindung von Einzelsolarzellen zu Modulen zu schaffen, die eine hohe Effizienz der Solarenergiewandlung und eine einfache Herstellungstechnik ermöglicht. Eine weitere Aufgabe ist die Schaffung eines neuartigen Verfahrens zur technischen Umsetzung derartiger Anordnungen. Insbesondere zielt das Verfahren auf die Rückseitenöffnung von Dünnschichtsolarzellen auf polymeren Trägern sowie auf die serielle elektrische Verschaltung dieser rückseitengeöffneten Solarzellen zur Modulherstellung.

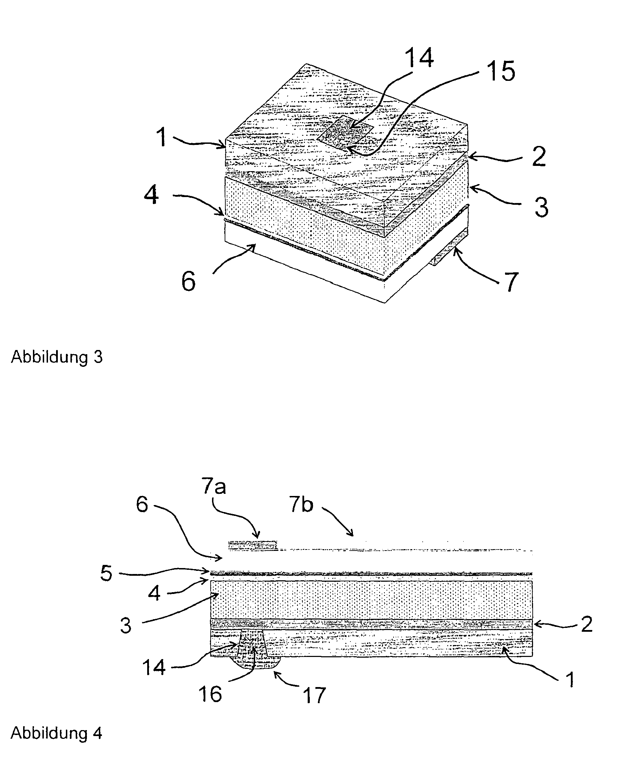

Erfindungsgemäß wird die Aufgabe dadurch gelöst, dass der auf dem polymeren Solarzellenträger hergestellte Rückkontakt der Dünnschichtsolarzelle durch Abtragen des polymeren Trägers (1) unter Anwendung von Laserstrahlung von der sonnenabgewandten Seite aus so freigelegt wird, vgl. Abbildung 3, so dass der Rückkontakt der Solarzelle (2) im Bereich der Öffnung (14) zugänglich wird und elektrisch kontaktiert werden kann. Die prinzipielle Anordnung der rückseitigen Kontaktierung ist in Abbildung 4 gezeigt. Nach Fertigung der Solarzellenschichten (2 bis 7) wird von der sonnenabgewandten Seite eine Öffnung (14) eingebracht, die den Rückkontakt freilegt und die elektrische Kontaktierung durch Einbringung eines elektrisch leitfähigen Materials (16) ermöglicht, wodurch die Solarzellenelektrode auf der Trägerfolienrückseite verfügbar wird (17). Zur Herstellung eines Sackloches (14) in der polymeren Solarzellenträgerfolie (1) mit dem Ziel der Freilegung der dünnen Rückkontaktschicht des Solarzellenrückkontaktes wird die Solarzellenträgerfolie im Bereich der herzustellenden Öffnung (14) von der sonnenabgewandten Seite mit einem gepulsten Laserstrahl (100) bestrahlt. Durch die Laserbestrahlung (üblicherweise Pulslaser mit Wellenlängen im VUV bis IR und Pulszeiten von Femtosekunden bis Millisekunden) wird das Material des polymeren Trägers abgetragen; dieser Prozess wird auch als Laserablation bezeichnet. Bei ausreichenden Energiedichten des Laserstrahls auf der Materialoberfläche wird das organische Material Puls für Puls um eine bestimmte Tiefe abgetragen und durch den dabei auftretenden Ablations- oder Verdampfungsdruck von der Oberfläche entfernt. Die Energiedichten sind so gewählt (10 mJ/cm² bis 10 J/cm²), dass sich das organische Trägermaterial der Solarzelle (1) effektiv und präzise abtragen lässt, gleichzeitig die Schichten bzw. das Schichtsystem (Rückkontakt/Absorber/Frontkontakt (2 bis 7)) der Solarzelle nicht abgetragen werden. Auch darf die Schwellenenergiedichte für die Aufschmelzung des Rückkontaktes (2) nicht überschritten werden. Die Schwellenenenergiedichten sind stark von den Prozessparametern, insbesondere von den Eigenschaften der Laserstrahlung, dem Aufbau und den Materialeigenschaften der Solarzelle, den Umgebungsbedingungen usw. abhängig und müssen entsprechend gewählt werden. Im übrigen kann die Dünnschichtsolarzelle auch auf Dünnschichtsilizium, CdTe, GaAs oder Varianten dieser Materialklassen basieren.

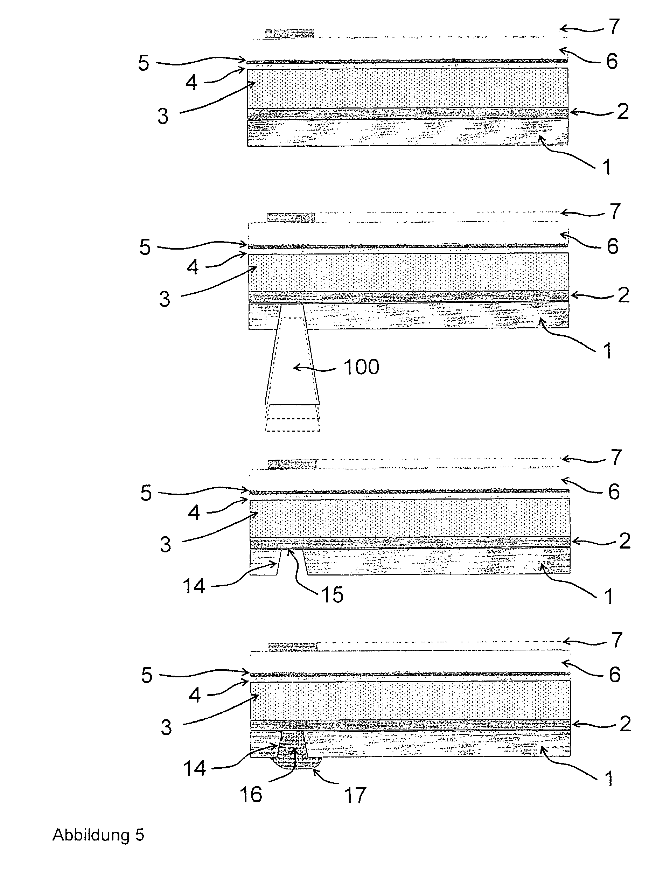

In besonderer Ausführung erfolgt die Laserbestrahlung (100) und damit die Freilegung des Rückkontaktes in dem bestrahlten Bereich (15) unter Herstellung einer Öffnung (14) in mehreren Schritten, wobei unterschiedliche Verfahrensparameter zur Anwendung kommen. Insbesondere werden unterschiedliche Laserfluenzen verwendet, wobei am Anfang der Bestrahlung höhere Laserfluenzen verwendet werden, die später, wenn nur noch Bruchteile der Ausgangsfoliendicke den Rückkontakt bedecken, so weit vermindert werden, dass der Rückkontakt bzw. das Solarzellenschichtpaket nicht abgetragen wird, vergleiche Abbildung 5.

Die lateralen Öffnungsgrößen sind mindestens in einer Dimension so zu begrenzen, dass die mechanische Stabilität des Solarzellenaufbaus im geöffneten Bereich nicht gefährdet wird. Die genauen Werte hängen u. a. vom Solarzellenaufbau und den Prozessparametern ab und werden für die vorliegende Erfindung in Beispielen präzisiert.

Anschließend erfolgt die Verfüllung der geschaffenen Öffnungen (14) mit einem leitfähigen Material (16) (z. B. Leitpasten, Leitkleber), wobei die freigelegten Flächenanteile des Rückseitenkontaktes (15) elektrisch kontaktiert werden und den Rückkontakt (2) für die nachfolgende Verschaltung auf die sonnenabgewandte Seite der Solarzelle führen. Die so geschaffenen rückseitigen Kontaktstellen (17) können zur Verschaltung der einzelnen Solarzellen miteinander genutzt werden. Darüber hinaus ist auch eine konventionelle Verschaltung mittels Drahtverbindungen an der Rückseite möglich.

In weiterer Ausführungen der Erfindung können mehrere Rückseitenöffnungen bzw.
Durchkontaktierungen zur Anwendung kommen, wenn die Anwendung dies erfordert. Die Anordnung der Öffnungen kann flächig über die Rückseite erfolgen oder sich nur über bestimmte Gebiete erstrecken. Zur seriellen Verschaltung von Dünnschichtsolarzellen zu Modulen in Schindeltechnik ist es vorteilhaft, die Öffnungen zur Kontaktierung nur auf den Überdeckungsbereich der zu verschaltenden Schindeln zu beschränken.

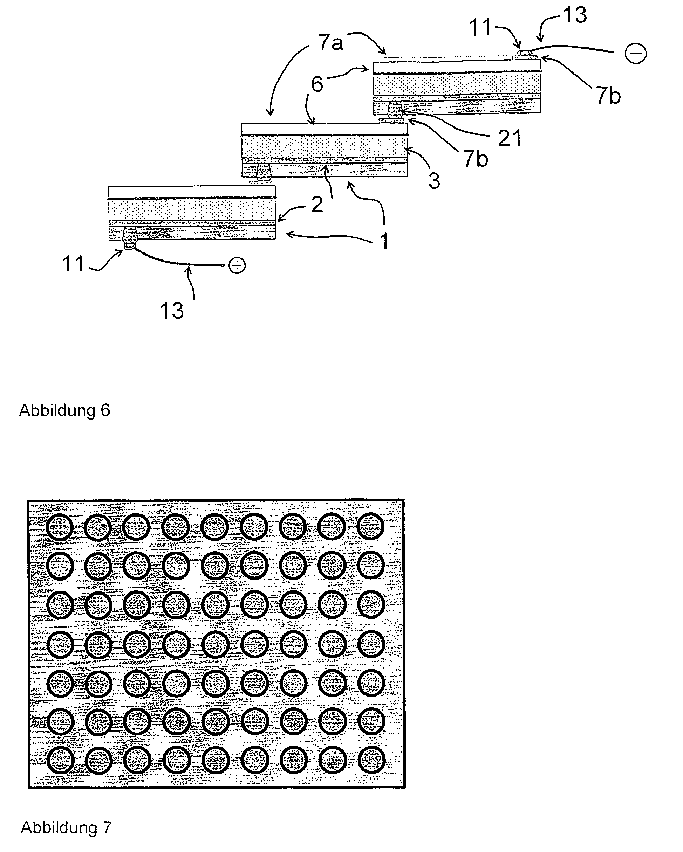

Die Herstellung von Modulen kann auf einfache Weise mittels durchkontaktierten Solarzellen erfolgen. Hierzu lässt sich die Schindeltechnik anwenden, wie in Abbildung 6 dargestellt ist. Zur Herstellung von linearen geometrischen Anordnungen (sog. strings) werden an gegenüberliegenden Seiten der Dünnschichtsolarzelle die Kontaktstellen des Vorderseiten- und Rückseitenkontaktes zur seriellen Verschaltung angebracht. Hierdurch lassen sich Fragen der elektrischen und mechanischen Verbindung vorteilhaft verknüpfen. Dies ist insbesondere dann nutzbringend, wenn die elektrische Kontaktierung mit Leitkleber erfolgt, der gleichzeitig zur Solarzellenoberfläche eine haftfeste Verbindung eingeht. In diesem Fall kann auch eine großflächige, zusammenhängende Verbindung der zu verschaltenden, benachbarten Solarzellen über alle Rückkontaktöffnungen erfolgen.

Durch die elektrische Kontaktierung des Rückkontaktes durch das Foliensubstrat ist eine größere Fläche der Solarzelle für Wandlung der einfallenden Sonnenenergie verfügbar, wodurch eine Effizienzsteigerung möglich ist. Hierdurch ergeben sich Vorteile für die Anordnung von Einzelzellen zur Serienverschaltung. Insbesondere können im Wesentlichen zusätzliche Elemente zur Realisierung der elektrischen Verbindung, beispielsweise Drähtchen, entfallen. Durch die geringere Anzahl an Komponenten wird die Montage stark vereinfacht, wodurch geringere Aufwendungen, höhere Energiewandlungsausbeuten im Modul und eine höhere Zuverlässigkeit erwartet werden kann. Hierdurch ergibt sich ein weiterer Vorteil, der in der einfachen Durchführung und guten Automatisierbarkeit des Verfahrens beruht.

Insbesondere für die Modulverschaltung von Einzelsolarzellen mit Rückseitenöffnung durch die Schindeltechnik ergibt sich ein sehr hoher Ausnutzungsgrad der Modulfläche. Bei Verwendung von Leitklebern mit ausreichender Festigkeit trägt die bei der seriellen Verschaltung hergestellte Klebeverbindung zwischen den Einzelzellen zur Montage der Einzelzellen bei und kann ggf. andere Verbindungsmethoden ablösen. Mit der neuartigen Anordnung bzw. dem beanspruchten Verfahren ist sichergestellt, dass der Prozess der Herstellung von Dünnschichtsolarzellen in konventioneller Weise sowie im Rolle-zu-Rolle-Betrieb möglich ist, wodurch einerseits keine Änderungen im technologischen Durchlauf der Herstellung der Dünnschichtsolarzellenflächen erforderlich sind, die Prozessabläufe jeweils separat optimiert werden können und so die Konfektionierung inklusive der elektrischen Verschaltung strikt nach der Flächenproduktion erfolgt.

### Beschreibung der Abbildungen

Die Erfindung soll nachstehend anhand von in der Zeichnung dargestellten Ausführungsbeispielen näher erläutert werden.

Es zeigen:
Abbildung 1: Schematischer Aufbau einer Dünnschichtsolarzelle auf Polymerträger im Querschnitt
Abbildung 2 Schematische Darstellung der seriellen Verschaltung von Dünnschichtsolarzellen auf Polymerträger
Abbildung 3 Schematische, perspektivische Darstellung einer Dünnschichtsolarzelle, wobei der lokal geöffnete Polymerträger dem Betrachter zugewandt ist
Abbildung 4 Schematische Querschnittsdarstellung einer Dünnschichtsolarzelle mit durchkontaktiertem Rückkontakt am Beispiel einer Chalkopyrit-Solarzelle
Abbildung 5 Schematische Darstellung der wesentlichen Schritte/Verfahren zur Rückseitenöffnung und Kontaktierung von Dünnschichtsolarzellen auf polymeren Trägern
Abbildung 6 Schematische Schnittdarstellung von drei seriell verschalteten Dünnschichtsolarzellen, bspw. Chalkopyrit-Dünnschichtsolarzellen.
Abbildung 7 Schema eines Arrays aus 50 µm durchmessenden Mikroabträgen zur Freilegung des Rückkontaktes.
Abbildung 8 Schema eines Array aus 1000 µm x 50 µm abmessenden Mikroabträgen zur Freilegung des Rückkontaktes.
Abbildung 9 Schema zum Freilegung des Rückkontaktes über einen Treppenabtrag zur verbesserten Einbringung des Leitklebers.

Bei der Prozessierung der Rückseitenöffnung mit dem Laser muss beachtet werden, dass sowohl bei zu hohen Energiedichten als auch bei zu großen laserbestrahlten Flächen der beim Materialabtrag auftretende Ablationsdruck den Rückkontakt und die Absorberschicht mechanisch schädigt. Zu hohe Energiedichten (750 mJ/cm², 150 Pulse) führen zur Zerstörung des Rückkontaktes und der Absorberschicht.

Die Erfindung wird nachstehend an Beispielen näher erläutert, ohne auf diese beschränkt zu sein.

### 1. Beispiel:

In Voruntersuchungen an einer Chalkopyrit-Solarzelle (Aufbau dargestellt in Abbildung 1; Polyimid-Träger 25 µm, Ti/Mo-Rückkontakt ca. 1000 nm, CIGS-Absorber ca. 1,5 µm, CdS-Pufferschicht ca. 50 nm, Tunnelkontaktschicht i-ZnO ca. 80 nm, ITO-Frontkontakt ca. 500 nm) zur Rückkontaktfreilegung mit einem Excimerlaser (λ = 248 nm, τₚ = 25 ns, Φ = 220 mJ/cm²) wurde ein 2-Stufen-Abtrag als günstig ermittelt, der in der ersten Stufe einen "Grobabtrag" mit 110 Pulsen bei einer Laserenergiedichte von 750 mJ/cm² und in der zweiten Stufe einen "Feinabtrag" mit 200 Pulsen mit einer Laserenergiedichte von 230 mJ/cm² vorsieht. Mit dieser Anordnung kann der Rückkontakt ohne relevante Beschädigung freigelegt werden. Die Voruntersuchungen zeigen weiterhin, dass bei der Freilegung unter der genannten Anordnung das Schichtsystem bis zu Flächen kleiner 75 µm x 75 µm unbeschädigt bleibt. Die freigelegten Flächen werden daher in dieser Schrift als Mikroabtrag bezeichnet. Wird die Fläche des Mikroabtrags unter den genannten Randbedingungen vergrößert, kommt es unter den angegebenen Bedingungen zur Zerstörung des Rückkontaktes und der Absorberschicht.

### 2. Beispiel:

Wenn eine laterale Dimension des Mikroabtrages im genannten Anwendungsfall kleiner 75 µm ist, kann die andere laterale Dimension vergrößert werden, ohne Rückkontakt und Absorber zu beschädigen.

### 3. Beispiel:

Die Größe der freigelegten Fläche kann weiter erhöht werden, wenn zur mechanischen Stabilisierung des Schichtsystems eine zusätzliche Trägerschicht auf die Frontseite der Solarzelle, beispielsweise durch Laminierung, aufgebracht wird. Im genannten Anwendungsbeispiel kann so die Fläche der lokalen Öffnung des Trägers in den Größenbereich von 350 µm x 350 µm erhöht werden.

### 4. Beispiel:

Um im Sinne einer Minimierung des Kontaktwiderstandes die effektiv freigelegte Fläche zu vergrößern, wird als Lösung die Aneinandersetzung von Mikroabträgen vorgeschlagen. Die Abstände zwischen den Mikroabträgen sind so zu gestalten, dass sich diese nicht gegenseitig beeinflussen (Ablagerungen von Abtragsprodukten, Wärmeeinflusszone, mechanische Spannungen im Schichtsystem). Da die üblicherweise zur Kontaktierung verwendeten Leitpasten/Leitkleber aus einer Mischung aus leitfähigen Mikro- und Nanopartikeln bestehen, muss eine möglichst große Anzahl/Dichte an Mikroabträgen erzeugt werden, um den Kontaktwiderstand der gesamten Solarzelle zu minimieren. In Abbildung 7 ist der Rückkontakt mit dem beschriebenen 2-Stufen-Abtrag durch ein Array, bestehend aus Löchern mit einem Durchmesser von 50 µm, freigelegt worden. Der relative Abstand zwischen den einzelnen Mikroabträgen beträgt 100 µm.

### 5. Beispiel:

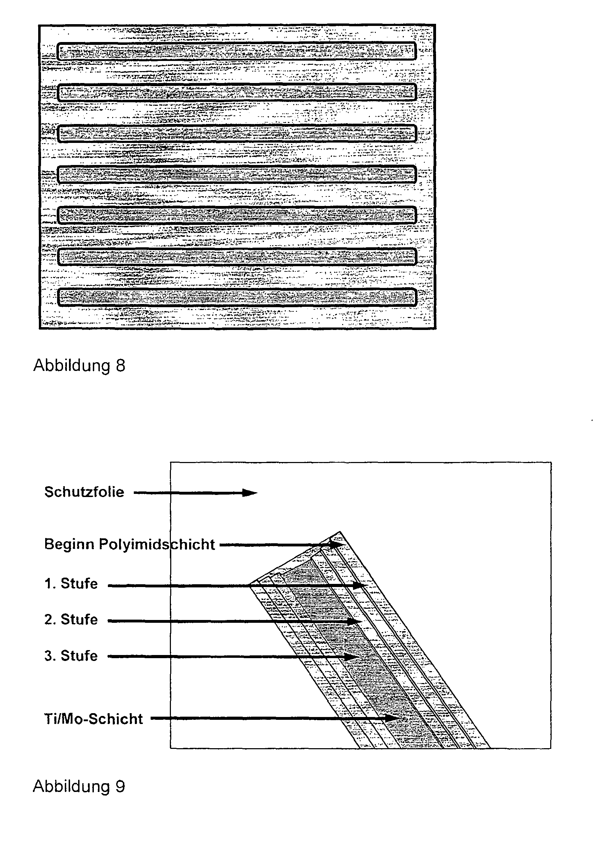

Bei relativ kleinen Mikroabträgen (z. B. bei den in Abbildung 7 gezeigten 50 µm-Löchern) gestaltet sich die anschließende Befüllung mit Leitpaste/Leitkleber aufgrund der Zusammensetzung der Pasten aus partikulären, metallischen Füllstoffen (Abmessungen im Mikrometerbereich) dahingehend schwierig, als dass die Kontaktierung des Rückkontaktes nur über wenige Mikropartikel stattfindet und so die effektive Kontaktfläche abnimmt und damit der Kontaktwiderstand ansteigt. Daher stellt es sich aus technologischer Sicht günstig dar, wenn die Fläche des einzelnen Mikroabtrages analog zu Verfahrensbeispiel 2 vergrößert wird und durch sequentielles Aneinandersetzen bzw. simultanes Laserbestrahlen ein Array mit großer effektiver Fläche erzeugt wird (Abbildung 8). Der relative Abstand zwischen den einzelnen Mikroabträgen beträgt 100 µm.

### 6. Beispiel:

Zur elektrischen Kontaktierung des freigelegten Rückkontaktes durch das Foliensubstrat hindurch und zur nachfolgend stattfindenden Modulverschaltung der Solarzelle mit weiteren Solarzellen kann z. B. der Leitkleber Epo-Tek H2OE-frozen von Polytec GmbH verwendet werden, der bei einer Temperatur von ca. 80 °C in die mit dem Laser erzeugten Mikroabträge eingebracht wird. Nach einer Aushärtezeit von ca. einer Stunde kann so eine elektrische und mechanische Verbindung zwischen dem freigelegten Rückkontakt der einen und dem Frontkontakt einer oder mehrerer anderer Solarzellen hergestellt werden.

### 7. Beispiel:

Um das Einbringen der/s Leitpaste/Leitklebers in die Rückseitenöffnung zu erleichtern, wird als Verfahrensbeispiel das Erzeugen einer Treppenstruktur in das polymere Trägermaterial vorgeschlagen. Um die Treppenstufen zu generieren, sind mehrere Arbeitsschritte mit dem Laser oder einer Laserstrahlformung mittels Grautonmaske (hier nicht beschrieben) nötig. Die Stufen werden jeweils einzeln mit dem Laser abgetragen und danach die Probe lateral versetzt, in der Reihenfolge, wie in Abbildung 9 zu sehen ist. Um die umliegende Rückseite des polymeren Trägers vor Abtragsprodukten zu schützen, kann im Vorfeld der Laserbearbeitung die sonnenabgewandte Seite der Solarzelle mit einer Schutzfolie versehen werden, die gleichzeitig als Transferfolie für den Solarzellenmodul-Herstellungsprozess dient. Die 1. bis 4. Treppenstufe wurde mit einer Laserenergiedichte von 750 mJ/cm² abgetragen. Die Stufen hatten dabei ein Tiefe von 4 µm (1. und 2. Schritt) und 8 µm (3. und 4. Schritt). Für den 5. Schritt wurde erneut der 2-Stufen-Abtragsprozess zur Freilegung des Rückkontaktes verwendet.

### 8. Beispiel:

Zur Unterstützung der Kontaktierung wird weiterhin eine nachträgliche Beschichtung der mit den Mikroöffnungen versehenen Rückseite mit einer leitfähigen Schicht vorgeschlagen, die die Stromabnahme über die aufzubringenden Kontakte aus Leitpaste/Leitkleber unterstützt.

### Legende zu den Abbildungen

| Nr | Beschreibung | Unterkategorien |
|---|---|---|
| 1 | Substrat der Dünnschichtsolarzelle | |
| 2 | Rückkontakt, Mo | |
| 3 | CIGS-Absorberschicht | |
| 4 | CdS-Schicht | |
| 5 | i-ZnO | |
| 6 | ITO | |
| 7 | Vorderseitenkontakt | a - Kontaktfinger |
| | | b - Sammelkontakt |
| 11 | Verbindungs- und Kontaktierungselement | |
| 12 | Verbindungsleitung | |
| 13 | Anschlussleitung | |
| 14 | Öffnung in der Trägerfolie | |
| 15 | Kontaktfläche der Solarzellenrückkontakte | |
| 16 | leitfähiges Material, z. B. Leitkleber | |
| 17 | rückseitig verfügbarer Rückkontakt | |
| 100 | Laserbestrahlung | |

## Patentansprüche

1. Modulverschaltung von Dünnschichtsolarzellen, **dadurch gekennzeichnet, dass** auf der Rückseite der Dünnschichtsolarzellen befindliche, mit leitfähigen Verbindungsmitteln ausgestattete Durchbrüche durch die polymere Trägerfolie Elektrodenkontaktpunkte darstellen, die mit Elektroden weiterer Dünnschichtsolarzellen parallel oder in Reihe geschaltet sind.

2. Modulverschaltung von Dünnschichtsolarzellen auf polymeren Trägern nach Anspruch 1, **dadurch gekennzeichnet, dass**
die Durchbrüche einen Durchmesser von 1 bis 1000 µm oder eine Kantenlänge der gleichen Abmessung aufweisen und ihre Tiefe der Polymerschicht entspricht.

3. Modulverschaltung von Dünnschichtsolarzellen auf polymeren Trägern nach Anspruch 1, **dadurch gekennzeichnet, dass**
die Modulverschaltung nach dem Schindelprinzip entsprechend Abb. 6 erfolgt, wodurch eine Reihenschaltung verwirklicht ist.

4. Modulverschaltung von Dünnschichtsolarzellen auf polymeren Trägern nach Anspruch 3, **dadurch gekennzeichnet, dass**
sich die Öffnungen zur Kontaktierung auf dem Überdeckungsbereich der Schindeln befinden.

5. Modulverschaltung von Dünnschichtsolarzellen auf polymeren Trägern nach Anspruch 1, **dadurch gekennzeichnet, dass**
das Verbindungsmittel ein leitfähiger Kleber oder eine leitfähige Paste ist.

6. Verfahren zur Herstellung von Dünnschichtsolarzellen auf polymeren Trägern mit der Eignung zur Modulverschaltung, **dadurch gekennzeichnet, dass**
a) die elektrische Kontaktierung von Dünnschichtsolarzellen auf organischem Träger durch Erzeugen von Öffnungen in dielektrischen Trägern der Dünnschichtsolarzelle zur Freilegung einer auf dem Träger liegenden dünnen Schicht oder Schichten und zur Herstellung eines elektrischen Kontaktes unter Verwendung dieser Öffnung erfolgt,
b) auf der Rückseite einer Dünnschichtschaltung der Großteil der Materialdicke des dielektrischen Trägers mit einem gepulsten Laserstrahl in zwei Schritten so entfernt wird, dass die Oberfläche der Öffnung im Träger der Energiedichteverteilung des Laserstrahles nachkommt, und die Reste des Trägers mit dem gleichen Laserstrahl so abgetragen werden, dass die Laserenergiedichte größer der Ablationsenergiedichte des Trägermaterials ist, jedoch die Zerstörenergie der dünnen Schicht nicht überschritten wird und die Parameter der Laserbestrahlung, insbesondere die Energiedichteverteilung und Laserstrahlauftrefffläche für den Abtrag so gewählt werden, dass die beim Ablationsabtrag auftretenden Kräfte nicht zur Beeinträchtigung der dünnen Schicht, wohl aber zum Abtrag des Dünnschichtträgers führen und die so hergestellte Öffnung mit einem leitfähigen Material teilweise oder vollständig beschichtet oder verfüllt wird.

7. Verfahren nach Anspruch 6, **dadurch gekennzeichnet, dass**
durch Laserablation in die polymere Trägerschicht Öffnungen eingebracht werden mit einem Durchmesser zwischen 1 und 1000 µm oder einer Kantenlänge der gleichen Größenordnung, wobei der Laser eine Energiedichte von 10 mJ/cm² bis 10 J/cm² aufweist.

8. Verfahren zur Herstellung von Dünnschichtsolarzellen nach den Ansprüchen 6 und 7, **dadurch gekennzeichnet, dass**
die Laserablation in mehreren Stufen und bei unterschiedlichen Energiedichten erfolgt und der Laserstrahl im Vakuum oder unter Schutzgas oder in Luft herangeführt wird, der Laserstrahl gepulst ist und die Pulszeiten im Bereich von Femto- bis Millisekunden liegen.

9. Verfahren zur Herstellung von Dünnschichtsolarzellen nach den Ansprüchen 6 bis 8, **dadurch gekennzeichnet, dass**
die Energiedichte im ersten Puls am größten ist.

10. Verfahren zur Herstellung von Dünnschichtsolarzellen nach den Ansprüchen 6 bis 9, **dadurch gekennzeichnet, dass**
die rückseitig erzielten Öffnungen miteinander durch metallische Leiter verbunden werden und eine Parallelschaltung entsteht.

11. Verfahren zur Herstellung von Dünnschichtsolarzellen nach den Ansprüchen 6 bis 10, **dadurch gekennzeichnet, dass**
eine serielle Verschaltung durch die Schindeltechnik entsprechend Abbildung 6 ermöglicht wird.
